# EUROPEAN PATENT SPECIFICATION

(11) **EP 2 195 853 B1**
(45) Date of publication and mention of the grant of the patent: **16.12.2015**
(21) Application number: 09732070.9
(22) Date of filing: 17.04.2009
(51) Int. Cl.: H01L 31/0224, H01L 31/0216, H01L 31/068, H01L 31/18

(54) **SOLAR CELL AND METHOD OF MANUFACTURING THE SAME**
SOLARZELLE UND HERSTELLUNGSVERFAHREN DAFÜR
CELLULE SOLAIRE ET SON PROCÉDÉ DE FABRICATION

(30) Priority: 17.04.2008 KR 20080035607; 25.02.2009 KR 20090015780
(43) Date of publication of application: 16.06.2010
(73) Proprietor: LG Electronics Inc., Seoul 150-721 (KR)
(72) Inventor: LEE, Daeyong, Seoul 137-130 (KR); JEONG, Jiweon, Seoul 137-130 (KR); LEE, Hyunho, Seoul 137-130 (KR)
(74) Representative: Gunzelmann, Rainer
(86) International application number: PCT/KR2009/002020
(87) International publication number: WO 2009/128678

(56) References cited:
- DE-A1-102006 046 726
- JP-A- 6 061 515
- KR-A- 20060 064 561
- KR-A- 20070 049 555
- US-A- 5 010 040
- DUPUIS J ET AL: "Impact of PECVD SiON stoichiometry and post-annealing on the silicon surface passivation", THIN SOLID FILMS, ELSEVIER-SEQUOIA S.A. LAUSANNE, CH, vol. 516, no. 20, 22 January 2008 (2008-01-22), pages 6954-6958, XP022777889, ISSN: 0040-6090, DOI: 10.1016/J.TSF.2007.12.026 [retrieved on 2008-01-22]
- LIPINSKI M ET AL: "Investigation of graded index SiOxNy antireflection coating for silicon solar cell manufacturing", PHYSICA STATUS SOLIDI (C), WILEY - VCH VERLAG, BERLIN, DE, vol. 4, no. 4, 1 January 2007 (2007-01-01) , pages 1566-1569, XP002639909, ISSN: 1610-1634, DOI: 10.1002/PSSC.200674143 [retrieved on 2007-03-30]
- NOBORU SHIBATA: "PLASMA-CHEMICAL VAPOR-DEPOSITED SILICON OXIDE/SILICON OXYNITRIDE DOUBLE-LAYER ANTIREFLECTIVE COATING FOR SOLAR CELLS", JAPANESE JOURNAL OF APPLIED PHYSICS, THE JAPAN SOCIETY OF APPLIED PHYSICS, JAPAN SOCIETY OF APPLIED PHYSICS, TOKYO; JP, vol. 30, no. 5, 1 May 1991 (1991-05-01), pages 997-1001, XP000263711, ISSN: 0021-4922, DOI: 10.1143/JJAP.30.997
- S. W. GLUNZ: "High-Efficiency Crystalline Silicon Solar Cells", ADVANCES IN OPTOELECTRONICS, vol. 2007, 1 January 2007 (2007-01-01), pages 1-15, XP55037262, ISSN: 1687-563X, DOI: 10.1155/2007/97370

## Description

### Technical Fiend

Embodiments of the present invention relate to a solar cell and a method of manufacturing the same.

### Background Art

A solar cell is an element capable of converting light into electrical energy, and may include a p-type semiconductor and an n-type semiconductor.

A general operation of a solar cell is as follows. If light is incident on a solar cell, electron-hole pairs are formed inside a semiconductor of the solar cell. The electrons move toward an n-type semiconductor and the holes move toward a p-type semiconductor by an electric field generated inside the semiconductor of the solar cell.

### Hence, a power is produced

The document DE102006046726 discloses rear side passivation coatings of solar cells, one of them (on figure 2) consisting for instance of a three layered structure SiOx/SiNx/SiOx.

### Disclosure of Invention

### Brief Description of Drawings

FIGS. 1, 2a and 3a include illustrations of a solar cell according to an embodiment of the present invention;
FIGS 2b and 3b illustrate comparative examples
FIG. 4 shows current- voltage characteristics of a solar cell including a passivation layer and a solar cell not including the passivation layer;
FIG. 5 showings efficiencies of a solar cell including a passivation layer and a solar cell not including the passivation layer;
FIGS. 6 and 7 illustrate example structures of passivation layers
FIGS. 8 to 11 illustrate an example method of manufacturing a solar cell according to an embodiment of the present invention;
FIGS. 12 and 13 illustrate another example method of manufacturing a solar cell according to another embodiment of the present invention;
FIG. 14 illustrates life spans of a solar cell depending on a firing process; and
FIGS. 15 and 16 illustrate example structures of a solar cell according to embodiments of the present invention.

### Mode for the Invention

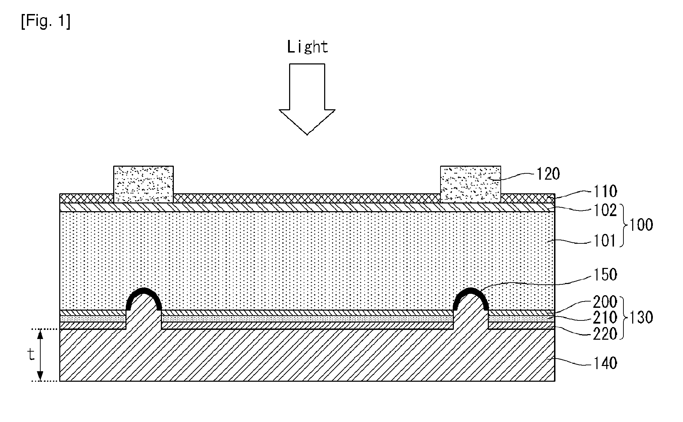

FIGS. 1, 2a and 3a include illustrations of a solar cell according to an embodiment of the present invention.

As shown in FIG. 1, a solar cell may include a semiconductor unit 100, an anti-reflective layer 110 and a front surface electrode 120 that are positioned on or over the semiconductor unit 100. A passivation layer 130 may be positioned on a side of, such as under, the semiconductor unit 100. A back surface electrode 140 may be positioned on the passivation layer 130.

The top and bottom of the semiconductor unit 100 may be reversed depending on a viewpoint. For example, if the top and bottom of the solar cell shown in FIG. 1 are reversed, it may be seen that the passivation layer 130 is positioned on the semiconductor unit 100 and the anti-reflective layer 110 and the front surface electrode 120 are positioned under the semiconductor unit 100.

It is considered in the embodiment that the surface (i.e., a light incident surface) of the semiconductor unit 100 on which light is incident is an upper surface of the semiconductor unit 100 for ease of description, but such should not be limiting.

The semiconductor unit 100 may include a p-type semiconductor unit 101 and an n-type semiconductor 102 that form a p-n junction.

If light incident on the solar cell, the light is converted into electrical energy in a junction surface between the p-type semiconductor 101 and the n-type semiconductor 102 to produce power.

FIG. 1 shows the semiconductor unit 100 having a structure in which the p-type semiconductor 101 and the n-type semiconductor 102 have a p-n junction between them.

In the embodiment of FIG. 1, the semiconductor unit 100 may include an amorphous silicon layer under a condition that the passivation layer 130 is positioned on a surface opposite the light incident surface of the semiconductor unit 100. Further, the semiconductor unit 100 may include a micro crystalline (or polycrystalline) silicon layer.

The anti-reflective layer 110 may be positioned on the semiconductor unit 100 to suppress a reflection of light incident on the semiconductor unit 100. Hence, reflectance of the light may be lowered. In other words, the anti-reflective layer 110 may increase an amount of light reaching the semiconductor unit 100 to thereby increase a photoelectric transformation efficiency (i.e., an efficiency of the solar cell).

The anti-reflective layer 110 may contain at least one of formation (constituent) materials of the passivation layer 130. For example, if the anti-reflective layer 110 may be formed of silicon nitride (SiNₓ) belonging to the formation materials of the passivation layer 130, functional layers of at least one same material are respectively formed on both surfaces of the semiconductor unit 100. For example, silicon nitride layers are respectively formed on both surfaces of the semiconductor unit 100.

The back surface electrode 140 may be formed of aluminum (Al). The back surface electrode 140 may be formed as a thick film electrode using a screen printing method. A thickness t of the back surface electrode 140 may be approximately 20 µm to 100 µm.

If the back surface electrode 140 is formed using an E-beam method, the back surface electrode 140 may be formed as a thin film electrode having a thickness of approximately 1 µm to 2 µm.

Because the back surface electrode 140 is formed using the screen printing method in one of the embodiments, the back surface electrode 140 may include A1 and a glass material.

A portion of the back surface electrode 140 may be electrically connected to the semiconductor unit 100 through the passivation layer 130 by way of patterning technologies using photo-lithography, mechanical scribing, etching paste or laser ablation.

The electrical connection of the back surface electrode 140 to the semiconductor unit 100 using the laser beam (laser ablation) will be described in detail later.

A back surface field (BSF) layer 150 may be formed between the portion of the back surface electrode 140 passing through the passivation layer 130 (e.g., a part of the black surface electrode 140 that is electrically connected to the semiconductor unit 100) and the semiconductor unit 100.

When the semiconductor unit 100 includes the p-type semiconductor 101 and the n-type semiconductor 102, the BSF layer 150 may be a P+ type semiconductor that is heavily doped with p-type impurities as compared with the p-type semiconductor 101.

The BSF layer 150 may improve the photoelectric transformation efficiency by reducing back surface defects (or surface defects in the back) of the semiconductor unit 100.

The passivation layer 130 between the semiconductor unit 100 and the back surface electrode 140 may increase a back surface reflectance (BSR) and may reduce a back surface recombination velocity (BSRV). For example, the passivation layer 130 may increase the BSR of the solar cell to approximately 80 % or more and may reduce the BSRV of the solar cell to approximately 500 cm/s.

As noted above, because the passivation layer 130 increases the BSR and reduces the BSRV, it is possible to reduce a thickness of the solar cell. For example, even if a solar cell is manufactured using a relatively thin silicon wafer, it is possible to manufacture the solar cell having a stable photoelectric transformation efficiency.

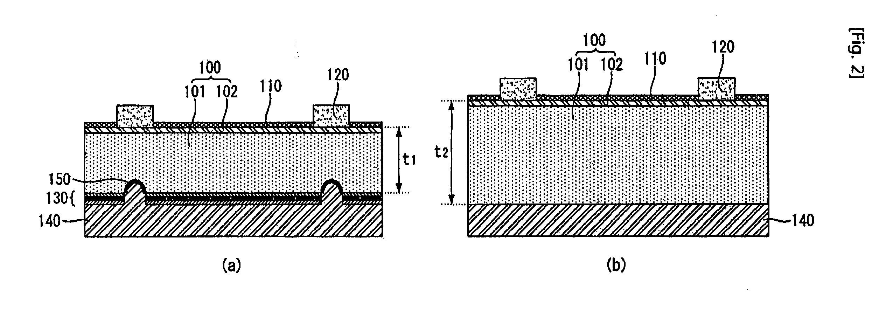

As shown in FIG. 2, (a) of FIG. 2 shows the passivation layer 130 being formed between the semiconductor unit 100 and the back surface electrode 140, and (b) of FIG. 2 shows the passivation layer 130 being omitted between the semiconductor unit 100 and the back surface electrode 140.

In (a) of FIG. 2, because the passivation layer 130 increases the BSR and reduces the BSRV, the semiconductor unit 100 can absorb light of a wide wavelength band even if a relatively thin silicon wafer is used (i.e., even if the semiconductor unit 100 has a smaller thickness t1). Hence, even if the relatively thin silicon wafer is used, the high photoelectric transformation efficiency can be obtained. Further, the manufacturing cost can be reduced due to less use of expensive silicon.

As shown in (a) of FIG. 2, if the passivation layer 130 is provided, a high photo-electric transformation efficiency can be obtained even if the thickness t1 of the silicon wafer is equal to or smaller than a thickness of a general silicon wafer lacking the passivation layer 130 (for example, even if the thickness t1 of the silicon wafer is equal to or smaller than approximately 200 µm). When the thickness t1 of the silicon wafer is equal to or greater than approximately 200 µm, when the passivation layer is present, the photoelectric transformation efficiency of the solar cell may increase further.

On the other hand, in (b) of FIG. 2, because the passivation layer 130 is omitted, the semiconductor unit 100 has to have a sufficiently great thickness t2 so as to obtain the high photoelectric transformation efficiency. In FIG. 2, the thickness t2 of (b) is greater than the thickness t1 of (a).

As shown in (b) of FIG. 2, if the passivation layer 130 is omitted, the thickness t2 of the silicon wafer has to be approximately 250 µm so as to obtain the high photoelectric transformation efficiency.

If the passivation layer 130 is omitted from the thin semiconductor (i.e., the thin silicon wafer), the thin semiconductor may absorb light of a narrow wavelength band. Hence, the photoelectric transformation efficiency may be reduced.

Further, if the passivation layer 130 is provided between the back surface electrode 140 and the semiconductor unit 100, a bowing phenomenon resulting from a difference between thermal expansion coefficients of the back surface electrode 140 and the semiconductor unit 100 can be reduced or prevented even if the thin silicon wafer is used.

The passivation layer 130 consists of first, second, and third layers 200, 210, and 220, respectively.

The second layer 210 consists of silicon nitride (SiNₓ) and may suppress a recombination of electrons and holes. The second layer 210 may be formed using a plasma enhanced chemical vapor deposition (PECVD) method. NH₃ and SiH₄ may be used as source gases in a process for forming the second layer 210. The second layer 210 may contain a large amount of hydrogen (H₂) because of the source gases used in the formation process of the second layer 210.

Hydrogen (H₂) contained in the second layer 210 may be combined with dangling bonds of silicon (Si) in an interface between the semiconductor unit 100 and the passivation layer 130 in a high temperature process to thereby reduce a recombination of electrons and holes. Hence, the BSRV of the solar cell is reduced, and the photoelectric transformation efficiency may increase.

As an amount of hydrogen contained in the second layer 210 increases, the BSRV may be reduced. An amount of each of NH₃ and SiH₄ may be adjusted in the formation process of the second layer 210 so as to increase the amount of hydrogen therein. Also, a refractive index of the second layer 210 may have a relatively large value depending on amounts of the source gases. That is, the refractive index of the second layer 210 may be controlled based on process conditions to form the second layer 210 from the source gases. For example, a refractive index of the second layer 210 may be approximately 2.2 to 3.0. Preferably, the refractive index of the second layer 210 may be approximately 2.3. The refractive index of the second layer 210 may be greater than a refractive index of the first layer 200 and contain a large amount of hydrogen.

The second layer 210 may have a thickness of approximately 10 nm to 100 nm so as to reduce a recombination of electrons and holes. Preferably, the thickness of the second layer 210 may be approximately 20 nm.

Referring back to FIG. 1, the first layer 200 consists of silicon oxide (SiOx). The first layer 200 is positioned between the second layer 210 and the semiconductor unit 100 to restrict or prevent a contact between the second layer 210 and the semiconductor unit 100. That is, in the embodiment of FIG. 1, the first layer 200 does not completely prevent the contact between the second layer 210 and the semiconductor unit 100. For example, the first layer 200 does not prevent the contact between the second layer 210 and the semiconductor unit 100 in a contact portion where a portion of the back surface electrode 140 is electrically connected to the semiconductor unit 100.

The first layer 200 may reduce or prevent a formation of an electron inversion layer induced by positive charges in the second layer 210 and a parasitic shunt of the back surface electrode 140. Hence, the efficiency of the solar cell may increase.

If the passivation layer 130 does not include the first layer 200, a contact area between the second layer 210 and the semiconductor unit 100 increases. Hence, charges of an electron inversion layer induced in an interface between the second layer 210 and the semiconductor unit 100 are sharply led into the back surface electrode 140. The efficiency of the solar cell may be excessively reduced in such a case.

A refractive index of the first layer 200 may be approximately 1.4 to 1.6. Preferably, the refractive index of the first layer 200 may be approximately 1.5.

The first layer 200 may have a thickness of approximately 10 nm to 300 nm so as to keep the efficiency of the solar cell at a high level. Preferably, the thickness of the first layer 200 may be approximately 200 nm.

The third layer 220 consists of silicon oxynitride (SiOxNy). The third layer 220 may restrict or prevent a material of the back surface electrode 140 from penetrating into the first and second layers 200 and 210.

If the passivation layer 130 included only the first and second layers 200 and 210, and if the screen printing method was used to form the back surface electrode 140 as the thick film electrode, a high-temperature firing process may be used to form the back surface electrode 140 using the screen printing method. Then, a material (i.e., A1 and glass material) of the back surface electrode 140 may penetrate into the first and second layers 200 and 210 at a high temperature in the high-temperature firing process. Hence, characteristics of the passivation layer 130 would be reduced, in such a case.

On the other hand, since the passivation layer 130 includes the third layer 230 in addition to the first and second layers 200 and 210, the material (i.e., A1 and glass material) of the back surface electrode 140 is restricted or prevented from penetrating into the first and second layers 200 and 210 in the high-temperature firing process. Hence, the characteristics of the passivation layer 130 are not reduced in such a case.

Thus, the third layer 230 of the passivation layer 130 makes it possible to form the back surface electrode 140 through the screen printing method including the high-temperature firing process. The screen printing method is advantageous because of a reduction in manufacturing time and the manufacturing cost.

It is required, that the third layer 220 of the passivation layer 130 is an outermost layer of the three layers constituting the passivation layer 130 so as to restrict or prevent the material of the back surface electrode 140 from penetrating into the passivation layer 130. Hence, the first, second, and third layers 200, 210, and 220 are positioned in the order named. That is, the first layer 200 contacts the semiconductor unit 100, the second layer 210 is over the first layer 200, and the third layer 220 is over the second layer 210.

The third layer 220 may restrict or prevent hydrogen contained in the second layer 210 from being discharged into the back surface electrode 140 to thereby improve a driving efficiency of the solar cell.

The third layer 220 may have a proper refractive index or a refractive index that is designed so that a wavelength band of light capable of being absorbed by the semiconductor unit 100 is increased due to an increase in a reflectance of light that is transmitted by the semiconductor unit 100. Preferably, though not required, the refractive index of the third layer 220 may be smaller than the refractive index of the second layer 210, and may be greater than the refractive index of the first layer 200, so as to increase the BSR.

For example, when the third layer 220 consists of silicon oxynitride (SiOxNy), the refractive index of the third layer 220 may be equal to or larger than the refractive index of the first layer 200 and may be smaller than the second layer 210.

For example, the refractive index of the third layer 220 consists of silicon oxynitride may be approximately 1.5 to 2.0, preferably, approximately 1.7.

The third layer 220 may have a thickness of approximately 100 nm to 300 nm so as to have the passivation characteristic. Preferable, the thickness of the third layer 220 may be approximately 200 nm.

Accordingly, using the preferred refractive indexes and the thicknesses of the first layer 200, the second layer 210, and the third layer 220 as an example, i.e., 1.5, 2.3, and 1.7, respectively, and 200nm, 20nm, and 200 nm, respectively, the passivation layer 130 according to this embodiment of the present invention includes a thick first layer 200, a thin second layer 210, and a thick third layer 220. Further, based on the respective refractive indexes of the first layer 200, the second layer 210, and the third layer 220, in view of the respective thicknesses, a light incident on the first layer 200 will be refracted toward the middle or the interior of the semiconductor unit 100 at an interface between the first layer 200 and the second layer 210 due to Snell's law, but the light will be refracted oppositely at an interface between the second layer 210 and the third layer 230 also due to Snell's law. That is, by having the sandwiched second layer 220 with the refractive index that is higher than those of the first layer 210 and the third layer 230, the reflection of the incident light is reduced. It should be noted that the use of the preferred refractive indexes and the thicknesses of the respective first layer 200, the second layer 210, and the third layer 220 is not required, so that use or control of the refractive indexes and the thicknesses of the first layer 200, the second layer 210, and the third layer 220 may be practiced to obtain an optimal or a desired amount of refraction of the incident light at the respective interfaces. Additionally, the thus refracted incident light may be reflected off the back surface electrode 140 to further improve the efficiency of the solar cell.

Considering the description of FIGS. 1 and 2, because the cost of the silicon wafer determines the manufacturing cost of the solar cell, it may be preferable, but required, that the thickness of the silicon wafer is reduced so as to reduce the manufacturing cost of the solar cell. However, if the thickness of the silicon wafer is reduced, a wavelength band of light capable of being absorbed by the solar cell decreases. Hence, the driving efficiency may be reduced.

Accordingly, in the present invention, the passivation layer 130 is formed between the semiconductor unit 100 and the back surface electrode 140 so as to decrease or prevent a reduction in the driving efficiency while reducing the thickness of the silicon wafer. Furthermore, when the back surface electrode 140, is formed using the screen printing method so as to reduce time required to form the back surface electrode 140 and the manufacturing cost of the back surface electrode 140, the passivation layer 130 includes the third layer 220 formed of silicon oxynitride (SiOxNy) as the outermost layer of the passivation layer 130. The third, layer 220 may decrease or prevent the characteristics of the passivation layer 130 from being reduced caused by the high-temperature firing process that is included in the screen printing method.

If the thickness of the silicon wafer is also reduced in a state where the passivation layer 130 is omitted, the manufacturing cost of the solar cell is reduced, but the driving efficiency of the solar cell is reduced due to the various reasons noted above.

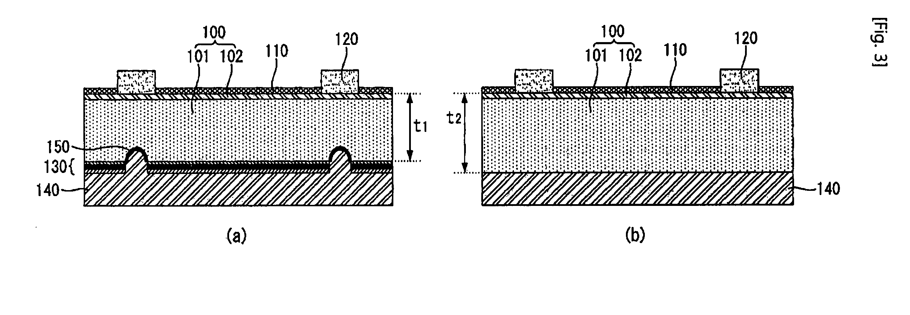

In FIG. 3, (a) of FIG. 3 shows the solar cell according to an embodiment of the present invention, and (b) of FIG. 3 shows a solar cell not including the passivation layer.

A thickness t2 of the semiconductor unit 100 shown in (b) of FIG. 3 is similar to a thickness t1 of the semiconductor unit 100 shown in (a) of FIG. 3. That is, a thickness of the silicon wafer of the solar cell shown in (b) of FIG. 3 and a thickness of the silicon wafer of the solar cell shown in (a) of FIG. 3 can be equal to each other (for example, approximately 200 µm).

In (b) of FIG. 3, because the thin silicon wafer is used and the back surface electrode 140 contacts the semiconductor unit 100, a bowing phenomenon occurs because of a difference between thermal expansion coefficients of the back surface electrode 140 and the semiconductor unit 100. Further, because the solar cell shown in (b) of FIG. 3 does not include the passivation layer, the BSR may be smaller than approximately 70 % and the BSRV may have a large value equal to or greater than approximately 1,000 cm/s. In contrast, the characteristics of the solar cell shown in (a) of FIG. 3 is improved due to the passivation layer 130.

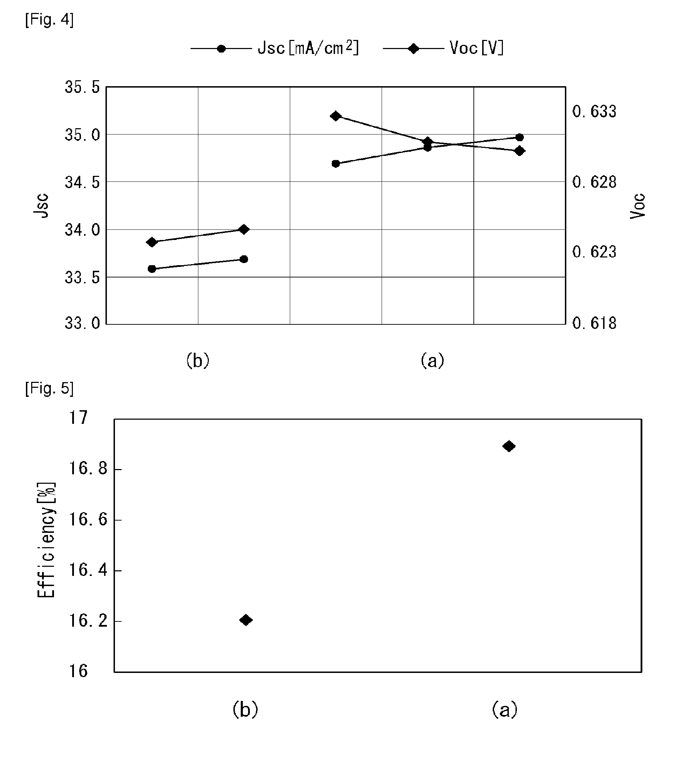

FIG. 4 is a graph showing current-voltage characteristics of the solar cell according to the embodiment of the present invention and a solar cell not including the passivation layer. In FIG. 4, (a) of FIG. 4 illustrates an experimental result conducted on three solar cell samples according to the embodiment, and (b) of FIG. 4 illustrates an experimental result conducted on two solar cell samples not including the passivation layer.

FIG. 5 is a graph showing efficiencies of the solar cell according to the embodiment of the present invention and a solar cell not including the passivation layer.

As shown in FIG. 4, in the solar cell shown in (b) of FIG. 4 not including the passivation layer in which a thickness of the silicon wafer is approximately 200 µm, Voc (open circuit voltage) was approximately 0.624V to 0.625V, and Jsc (short circuit current density) was approximately 33.6 mA/cm² to 33.7 mA/cm².

In the solar cell shown in (a) of FIG. 4 including the passivation layer 130 in which a thickness of the silicon wafer is approximately 200 µm, Voc was approximately 0.630V to 0.633V, and Jsc was approximately 34.7 mA/cm<2> to 35.0 mA/cm<2>.

It can be seen from FIG. 4 that the solar cell according to the embodiment of the present invention having the passivation layer shown in (a) of FIG. 4 has more excellent characteristics than the solar cell shown in (b) of FIG. 4 that lacks the passivation layer.

In the solar cell shown in (b) of FIG. 4 using the relatively thin silicon wafer, the photoelectric transformation efficiency is reduced because of a narrow wavelength band of light capable of being absorbed by the semiconductor unit 100. On the other hand, in the solar cell according to the embodiment using the relatively thin silicon wafer, the passivation layer 130 between the back surface electrode 140 and the semiconductor unit 100 increases the BSR and reduces the BSRV. Hence, the current-voltage characteristic is improved because of a wide wavelength band of light capable of being absorbed by the semiconductor unit 100 having the passivation layer.

Thus, it can be seen from FIG. 5 that the efficiency of the solar cell according to the embodiment shown in (a) of FIG. 5 is much greater than the efficiency of the solar cell shown in (b) of FIG. 5.

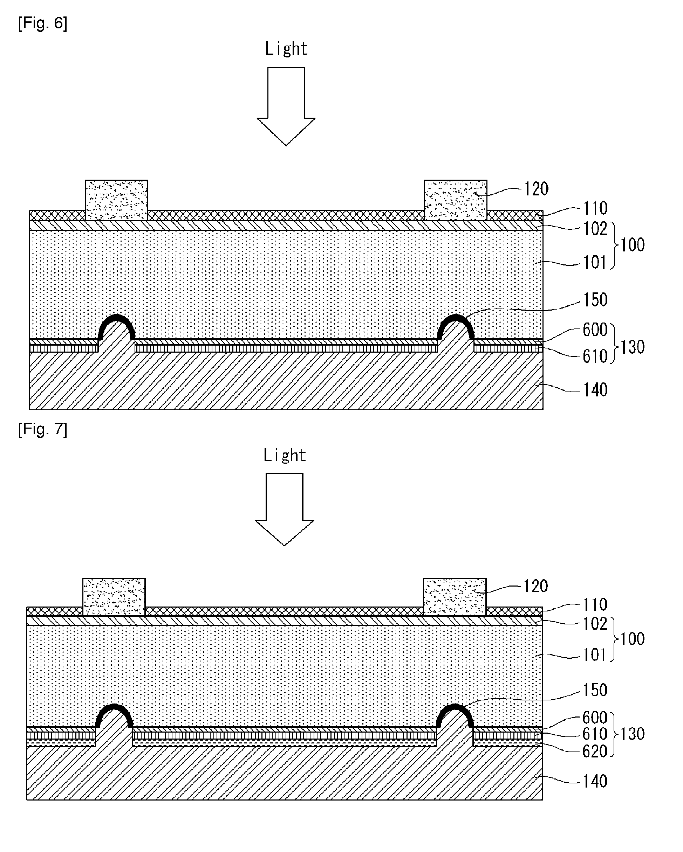

FIGS. 6 and 7 illustrate example structures of the passivation layer not forming part of the present invention. FIG. 6 illustrates the passivation layer having a two-layered structure including first and second layers 600 and 610. The first layer 600 may contain silicon oxide (SiOx), and the second layer 610 may contain silicon oxynitride (SiOxNy).

The first layer 600 shown in FIG. 6 may contain the substantially same material as the first layer 200 shown in FIG. 1, and the second layer 610 shown in FIG. 6 may have the same functions of the second and third layers 210 and 220 as shown in

FIG. 1. The first layer 600 may have a refractive index of approximately 1.4 to 1.6 and a thickness of approximately 10 nm to 300 nm.

The second layer 610 shown in FIG. 6 may contain the substantially same material as the third layer 220 shown in FIG. 1. The sufficiently thick second layer 610 may reduce a recombination of electrons and holes.

The second layer 610 may restrict or prevent the formation material of the back surface electrode 140 from penetrating into the first layer 600. More specifically, the second layer 610 may restrict or prevent Al forming the back surface electrode 140 from penetrating into the first layer 600 in the high-temperature firing process of the back surface electrode 140. Hence, the screen printing method may be used to form the back surface electrode 140.

A thickness of the second layer 610 may be greater than the thickness of the third layer 220 so that the second layer 610 acts as a replacement for the second and third layers 210 and 220. Hence, the second layer 610 may perform functions of the second and third layers 210 and 220. The thickness of the second layer 610 may be greater than a thickness of the first layer 600 so that the second layer 610 has the sufficient thickness. The thickness of the second layer 610 may be approximately 100 nm to 300 nm.

A refractive index of the second layer 610 may be greater than a refractive index of the first layer 600, so that a wavelength band of light capable of being absorbed by the semiconductor unit 100 increases due to an increase in a reflectance of light transmitted by the semiconductor unit 100. Preferably, the refractive index of the second layer 610 may be approximately 1.5 to 2.0.

FIG. 7 illustrates the passivation layer 130 including a third layer 620 in addition to the first and second layers 600 and 610.

The third layer 620 may contain silicon oxynitride (SiOxNy) or silicon oxide (SiOₓ). The third layer 620 of the passivation layer 130 may further increase a passivation effect of the passivation layer 130. A refractive index of the third layer 620 may be equal to or smaller than a refractive index of the second layer 610 and may be equal to or greater than the refractive index of the first layer 600.

For example, when the third layer 620 is formed of SiOx, the refractive index of the third layer 620 may be substantially equal to the refractive index of the first layer 600 formed of SiOx and may be smaller than the refractive index of the second layer 610. When the third layer 620 is formed of SiOxNy, the refractive index of the third layer 620 may be substantially equal to the refractive index of the second layer 610 formed of SiOxNy and may be greater than the refractive index of the first layer 600.

As described above, the third layer 620 may contain the substantially same material (i.e., SiOxNy) as the second layer 610. Nevertheless, even if the second and third layers 610 and 620 contain the same material, the refractive indexes of the second and third layers 610 and 620 may be different from each other by adjusting process conditions, such as a composition ratio of gases inside a plasma chamber and a temperature of the plasma chamber, during a process for forming each of the second and third layers 610 and 620 via different manners.

As described above, the third layer 620 may contain the substantially same material (i.e., SiOx) as the first layer 600. Nevertheless, even if the first and third layers 600 and 620 contain the same material, the refractive indexes of the first and third layers 600 and 620 may be different from each other by adjusting process conditions during a process for forming each of the first and third layers 600 and 620 via different manners.

Accordingly, the first layer 600 is thicker than the second layer 610, and the refractive index of the first layer 600 is generally less than the second layer 610. Thus, a light incident on the first layer 600 will be refracted toward the middle or the interior of the semiconductor unit 100 at an interface between the first layer 600 and the second layer 610 due to Snell's law. With the noted arrangement of the various layers, the reflection of the incident light is reduced.

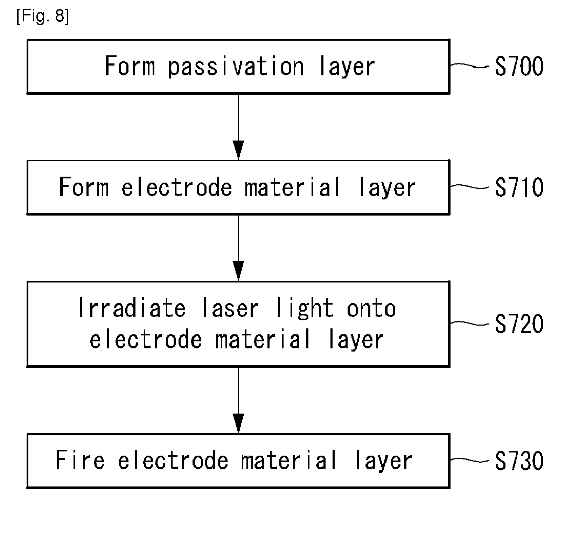

FIGS. 8 to 11 illustrate an exemplary method of manufacturing the solar cell according to an embodiment.

As shown in FIG. 8, an exemplary method of manufacturing the solar cell according to an embodiment may include operation S700 for forming a passivation layer on a semiconductor unit, operation S710 for forming an electrode material layer on the passivation layer, operation S720 for irradiating a laser beam onto the electrode material layer, and operation S730 for firing the electrode material layer.

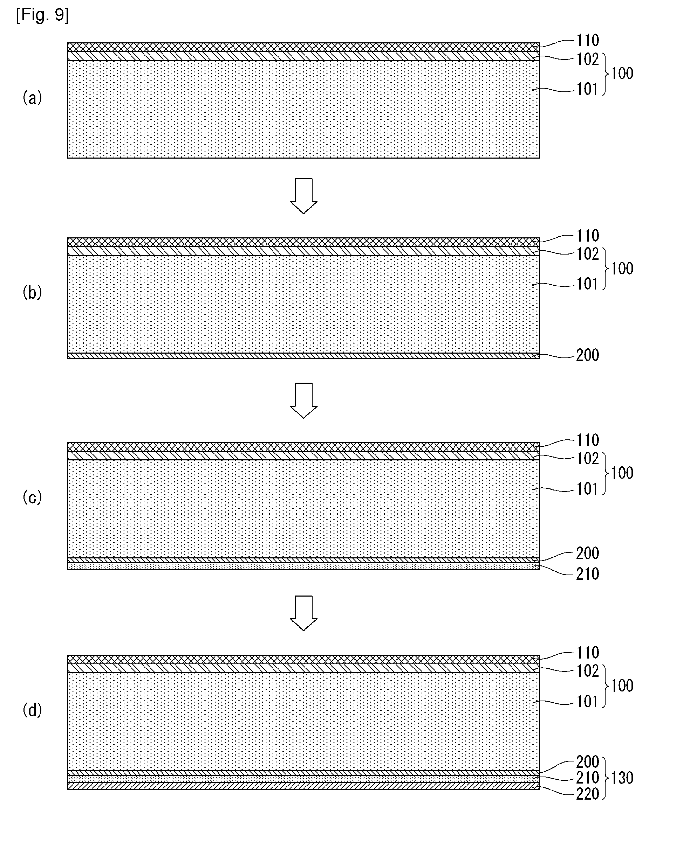

More specifically, as shown in (a) of FIG. 9, a thermal diffusion process of using POCl₃ is performed on the p-type semiconductor 101 to form an n-type semiconductor 102 on a surface of the p-type semiconductor 101. Hence, the semiconductor unit 100 including a p-n junction is formed. Then, an anti-reflective layer 110 is formed on the surface of the semiconductor unit 100 over the n-type conductor 102. More specifically, the semiconductor unit 100 is positioned inside the chamber of a predetermined gas atmosphere, and then silicon nitride is deposited on the n-type semiconductor 102 of the semiconductor unit 100 inside a chamber using a chemical vapor deposition (CVD) method to form the anti-reflective layer 110.

Next, as shown in (b) of FIG. 9, the first layer 200 is formed on the other surface of the semiconductor unit 100. More specifically, silicon oxide is deposited on the other surface of the semiconductor unit 100 through a PECVD method using SiH₄ and NO₂ as source gases to form the first layer 200 containing silicon oxide.

Next, as shown in (c) of FIG. 9, the second layer 210 is formed on the first layer 200. More specifically, silicon nitride is deposited on the first layer 200 through a PECVD method using SiH₄ and NH₃ as source gases to form the second layer 210.

Next, as shown in (d) of FIG. 9, the third layer 220 is formed on the second layer 210. More specifically, silicon oxynitride is deposited on the second layer 210 through a PECVD method using SiH₄, NO₂, and NH₃ as source gases to form the third layer 220.

In each of the processes illustrated in (b), (c), and (d) of FIG. 9, refractive indexes of the first, second, and third layers 200, 210, and 220 are adjusted by adjusting process conditions, such as injection amounts of the source gases, injection rates of the source gases, and partial pressures of the source gases.

More specifically, in the process illustrated in (b) of FIG. 9, the source gases are adjusted so that a refractive index of the first layer 200 is approximately 1.4 to 1.6. In the process illustrated in (c) of FIG. 9, the source gases are adjusted so that a refractive index of the second layer 210 is greater than the refractive index of the first layer 200, preferably, approximately 2.2 to 3.0. In the process illustrated in (d) of FIG. 9, the source gases are adjusted so that a refractive index of the third layer 220 is smaller than the refractive index of the second layer 210, preferably, approximately 1.5 to 2.0. The passivation layer 130 including the first, second, and third layers 200, 210, and 220 is formed through the above-described processes.

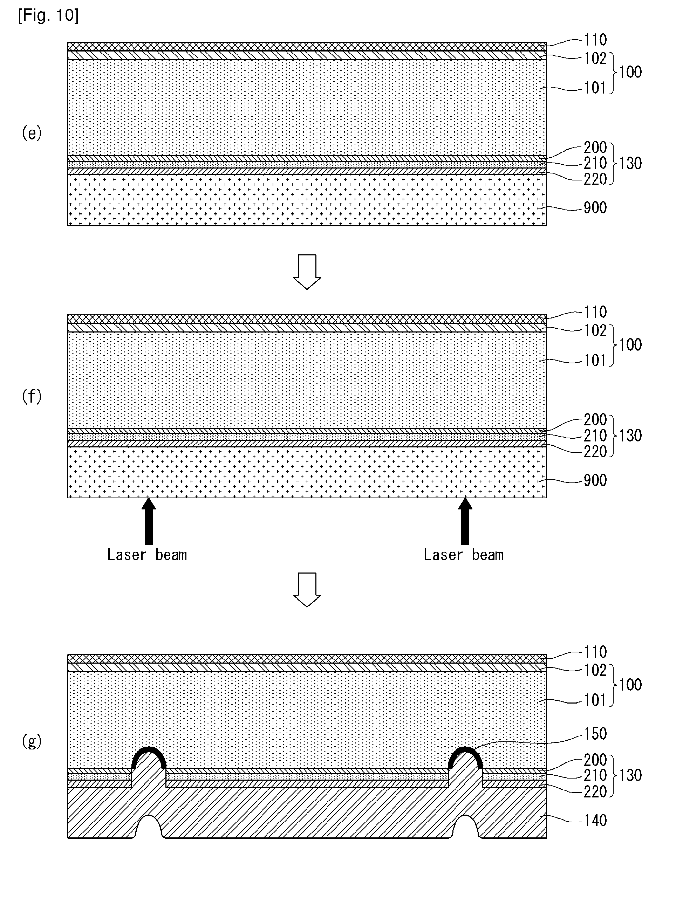

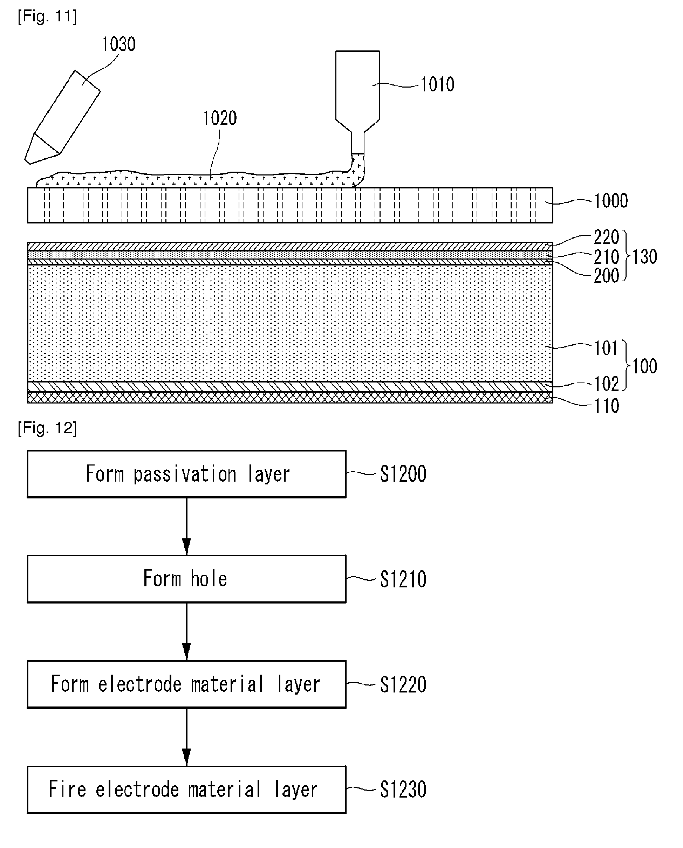

Next, as shown in (e) of FIG. 10, an electrode paste is coated on the passivation layer 130 to form an electrode material layer 900. A screen printing method is used to form the electrode material layer 900. More specifically, as shown in FIG. 11, a metal powder, a solvent, and a glass powder are mixed to form an electrode paste 1020. The metal powder may include A1 for a formation of a back surface electrode. The glass frit (powder) is added so as to smoothly form the back surface electrode.

Next, the electrode paste 1020 is coated on a screen mask 1000 having a predetermined pattern using a paste supply device 1010. Then, the electrode paste 1020 on the screen mask 1000 is coated on the passivation layer 130 using a squeezer 1030.

As a result, as shown in (e) of FIG. 10, the electrode material layer 900 is formed on the passivation layer 130.

As described above, when the screen printing method is used to form the electrode material layer 900, the back surface electrode 140 obtained by firing the electrode material layer 900 in a succeeding process is formed in the form of a thick film electrode. Because the electrode paste 1020 is used in the screen printing method, the back surface electrode 140 may include a glass material as well as a metal material.

Next, as shown in (f) of FIG. 10, a laser beam is irradiated onto the electrode material layer 900, and thus a portion of the electrode material layer 900 is electrically connected to the semiconductor unit 100 through the passivation layer 130. More specifically, the metal particle of the electrode material layer 900, a portion of the passivation layer 130, and a portion of the semiconductor unit 100 are melted because of a high energy (or heat) of the laser beam that is irradiated onto the electrode material layer 900. As a result, the back surface electrode 140 and the semiconductor unit 100 are electrically connected to each other through a hole formed in the passivation layer 130.

Next, as shown in (g) of FIG. 10, if the electrode material layer 900, to which the laser beam is irradiated, is fired at a high temperature, impurities (for example, the solvent) contained in the electrode material layer 900 is burn out. In other words, the solvent is removed from the electrode material layer 900, and the back surface electrode 140 is formed using the metal material and the glass material remaining in the electrode material layer 900. In a process for firing the electrode material layer 900, the solvent is not completely removed from the electrode material layer 900, and a small amount of solvent as an impurity may remain in the electrode material layer 900. However, even if a very small amount of impurities remains, it can be understood that the back surface electrode 140 formed through the firing process is essentially formed of the metal material and the glass material.

In the firing process, a firing temperature has to be a temperature at which the solvent can be burned off and the metal material and the glass material can be melted or fused. For example, the firing temperature may be equal to or higher than approximately 700°C.

As discussed above, because the firing temperature of the electrode material layer 900 is equal to or higher than 700°C, the passivation layer 130 has to endure a high temperature equal to or higher than 700°C.

If the firing process is performed at a high temperature equal to or higher than 700°C, the metal material (i.e., Al) and the glass material contained in the electrode material layer 900 may penetrate into the semiconductor unit 100. Thus, the passivation layer 130 has to restrict or prevent A1 and the glass material from penetrating into the semiconductor unit 100. For this, the passivation layer 130 includes the third layer 220 shown in FIG. 1 or the second layer 610 shown in FIGS. 6 and 7.

As discussed above, because the passivation layer 130 includes the third layer 220 shown in FIG. 1, the passivation layer 130 can restrict or prevent the material contained in the electrode material layer 900 from penetrating into the semiconductor unit 100 even if the electrode material layer 900 is fired at the high temperature.

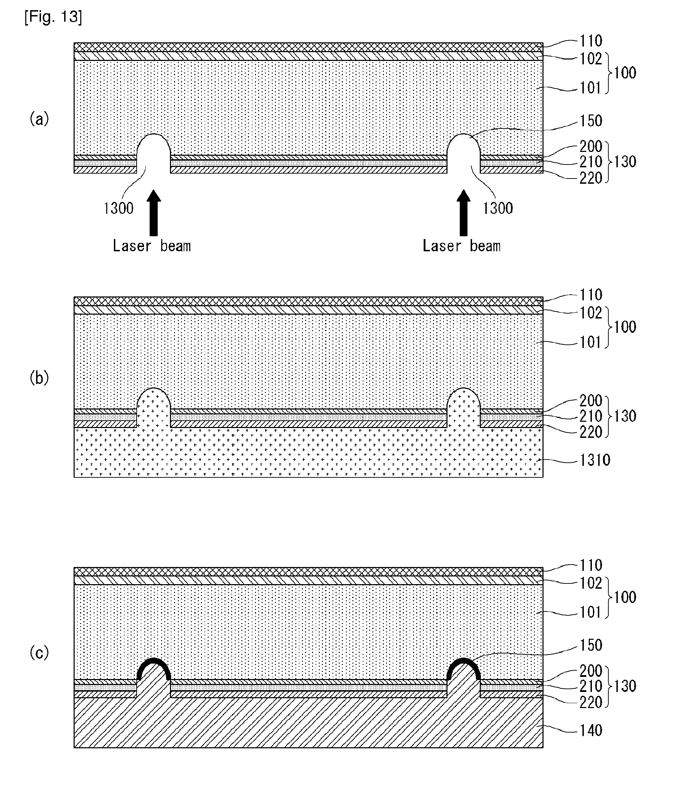

FIGS. 12 and 13 illustrate another exemplary method of manufacturing the solar cell according to an embodiment.

As shown in FIG. 12, the passivation layer 130 is formed on the semiconductor unit 100 in operation S1200.

Next, holes 1300 are formed on the passivation layer 130 in operation S1210. More specifically, as shown in (a) of FIG. 13, the holes 1300 may be formed on a portion of the semiconductor unit 100 as well as the passivation layer 130. The holes 1300 may be formed by irradiating a laser beam onto the passivation layer 130.

Next, as shown in (b) of FIG. 13, an electrode paste is coated on the passivation layer 130 having the holes 1300 to form an electrode material layer 1310 in operation S1220. A screen printing method is used to coat the electrode paste. In operation S1220, the electrode paste may penetrate into the holes 1300 as well as the surface of the passivation layer 130.

Next, as shown in (c) of FIG. 13, a firing process is performed on the electrode material layer 1310 to form the back surface electrode 140 on the passivation layer 130.

In the method illustrated in FIGS. 8 to 11, the back surface electrode 140 is electrically connected to the semiconductor unit 100 by forming the electrode material layer 900 on the passivation layer 130 and then irradiating the laser beam on the electrode material layer 900 so that a hole is formed in the passivation layer 130 by way of the electrode material layer 900. On the other hand, in the method illustrated in FIGS. 12 and 13, the back surface electrode 140 is electrically connected to the semiconductor unit 100 by forming the holes 1300 on the passivation layer 130, and then coating the electrode paste.

By directly irradiating the laser beam on the passivation layer 130, a planarization level of the back surface electrode 140 manufactured by the method illustrated in FIGS. 12 and 13 may be greater than a planarization level of the back surface electrode 140 manufactured by the method illustrated in FIGS. 8 to 11 that irradiates the laser beam on the electrode material layer.

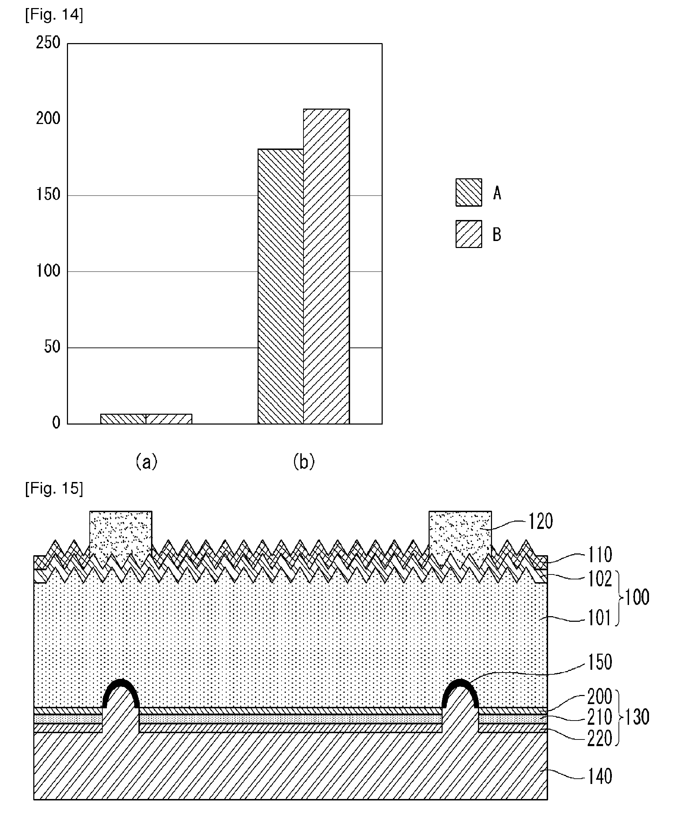

FIG. 14 illustrates life span of a solar cell depending on a firing process. In FIG. 14, (a) illustrates a solar cell on which a firing process is not performed, and (b) illustrates a solar cell on which a firing process is performed at a high temperature equal to or higher than 700°C. In FIG. 14, "A" illustrates a solar cell including a passivation layer having a two-layered structure including a first layer formed of silicon oxide and a second layer formed of silicon nitride, and "B" illustrates a solar cell according to the invention with a passivation layer having a three-layered structure of a first layer formed of silicon oxide, a second layer formed of silicon nitride, and a third layer formed of silicon oxynitride.

It can be seen from FIG. 14 that a life span of the solar cell in (b) of FIG. 14 in which the firing process is performed is much longer than life span of the solar cell in (a) of FIG. 14 in which the firing process is not performed.

Further, even if the firing process is performed, life span of the solar cell in the passivation layer "B" including silicon oxide, silicon nitride, and silicon oxynitride is longer than life span of the solar cell in the passivation layer "A" including silicon oxide and silicon nitride.

A reason why the life span of the solar cell in the passivation layer "B" is longer than the life span of the solar cell in the passivation layer "A" is that the third layer formed of silicon oxynitride is added and the third layer prevents hydrogen contained in the second layer formed of silicon nitride from being discharged to the outside.

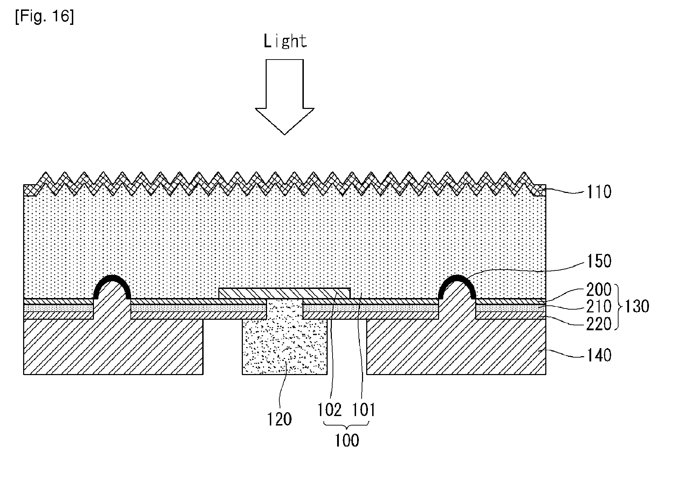

FIGS. 15 and 16 illustrate an exemplary structure of a solar cell according to an embodiment. As shown in FIG. 15, an uneven (or non-planar) portion may be formed on a p-n junction portion of the semiconductor unit 100. In this case, because an area of a light receiving surface increases due to the uneven portions, the photoelectric transformation efficiency (i.e., the efficiency of the solar cell) may be improved.

As shown in FIG. 16, the front surface electrode 120 and the back surface electrode 140 may be positioned on a surface opposite the light incident surface due to the uneven portions and the lack of the front surface electrode 120 therein. In this case, because an area of a light receiving surface increases, the photoelectric transformation efficiency (i.e., the efficiency of the solar cell) may be improved.

When the front surface electrode 120 is positioned on the surface opposite the light incident surface, the n-type semiconductor 102 (i.e., an emitter layer) may also be positioned on the surface opposite the light incident surface.

In embodiments of the present invention, reference to front or back, with respect to electrode, a surface of the substrate, or others is not limiting. For example, such a reference is for convenience of description since front or back is easily understood as examples of first or second of the electrode, the surface of the substrate or others.

## Claims

1. A solar cell, comprising:
a semiconductor unit (100) including a first type semiconductor (101) and a second type semiconductor (102);
a first electrode (120) and a second electrode (140) electrically connected to the semiconductor unit (100); and
a passivation layer (130) between the semiconductor unit (100) and the second electrode (140), said passivation layer (130) being positioned on a surface opposite the light incident surface of the semiconductor unit (100), wherein
the passivation layer (130) is a three layered structure which consists of a first layer (200) consisting of silicon oxide (SiOx), said first layer (200) contacting the semiconductor unit (100), a second layer (210) consisting of silicon nitride (SiNx) on the first layer (200), and a third layer (220) consisting of silicon oxynitride (SiOxNy) on the second layer (210), said third layer (220) contacting the second electrode (140), and wherein
a refractive index of the first layer (200) is smaller than a refractive index of the second layer (210), and
a refractive index of the third layer (220) is smaller than the refractive index of the second layer (210) and is greater than the refractive index of the first layer (200).

2. The solar cell of claim 1, wherein the second layer (210) contains hydrogen (H2).

3. The solar cell of claim 1, wherein a portion of the second electrode (140) is electrically connected to the semiconductor unit (100) through the passivation layer (130).

4. The solar cell of claim 3, further comprising a back surface field layer (150) between the portion of the second electrode (140), which is electrically connected to the semiconductor unit (100) through the passivation layer (130) and the semiconductor unit (100).

5. A method of manufacturing a solar cell according to claim 1 including a semiconductor unit (100), a second electrode (140) which is a rear electrode (140), and a passivation layer (130) between the semiconductor unit and the rear electrode, the method comprising:
forming the passivation layer (130) on a surface opposite the light incident surface of the semiconductor unit;
forming a hole through the passivation layer; and
forming an electrode material layer and firing the electrode material layer to form the electrode on the passivation layer, wherein
the forming of the passivation layer on the semiconductor unit consists of:
forming a silicon oxide (SiOx) layer contacting the semiconductor unit;
forming a silicon nitride (SiNx) layer on the silicon oxide layer; and
forming a silicon oxynitride (SiOxNy) layer on the silicon nitride layer.

6. The method of claim 5, wherein the forming of the hole includes irradiating a laser beam onto the passivation layer.

7. The method of claim 5, wherein the forming of the hole occurs after the forming of the electrode layer, and includes irradiating a laser beam onto the electrode material layer.

## Patentansprüche

1. Solarzelle, die umfasst:
eine Halbleitereinheit (100), die einen ersten Halbleitertyp (101) und einen zweiten Halbleitertyp (102) umfasst;
eine erste Elektrode (120) und eine zweite Elektrode (140), die elektrisch mit der Halbleitereinheit (100) verbunden sind; und
eine Passivierungsschicht (130) zwischen der Halbleitereinheit (100) und der zweiten Elektrode (140), wobei die Passivierungsschicht (130) auf einer Oberfläche gegenüber der Lichteinfallsoberfläche der Halbleitereinheit (100) positioniert ist, wobei
die Passivierungsschicht (130) eine dreilagige Struktur ist, die aus einer ersten Schicht (200) aus Siliziumoxid (SiOx), wobei die erste Schicht (200) in Kontakt mit der Halbleitereinheit (100) steht,
einer zweiten Schicht (210) aus Siliziumnitrit (SiNx) auf der ersten Schicht (200) und
einer dritten Schicht (220) aus Siliziumoxynitrid (SiOxNy) auf der zweiten Schicht (210) besteht, wobei die dritte Schicht (220) mit der zweiten Elektrode (140) in Kontakt steht, und wobei
ein Brechungsindex der ersten Schicht (200) kleiner als ein Brechungsindex der zweiten Schicht (210) ist, und
ein Brechungsindex der dritten Schicht (220) kleiner als der Brechungsindex der zweiten Schicht (210) ist und größer als der Brechungsindex der ersten Schicht (200) ist.

2. Solarzelle gemäß Anspruch 1, wobei die zweite Schicht (210) Wasserstoff (H2) enthält.

3. Solarzelle gemäß Anspruch 1, wobei ein Abschnitt der zweiten Elektrode (140) durch die Passivierungsschicht (130) elektrisch mit der Halbleitereinheit (100) verbunden ist.

4. Solarzelle gemäß Anspruch 3, die ferner eine Rückseitenfeldschicht (150) zwischen dem Abschnitt der zweiten Elektrode (140), der durch die Passivierungsschicht (130) elektrisch mit der Halbleitereinheit (100) verbunden ist, und der Halbleitereinheit (100) umfasst.

5. Verfahren zum Herstellen einer Solarzelle gemäß Anspruch 1, die eine Halbleitereinheit (100), eine zweite Elektrode (140), die eine rückseitige Elektrode (140) ist, und eine Passivierungsschicht (130) zwischen der Halbleitereinheit und der rückseitigen Elektrode umfasst, wobei das Verfahren umfasst:
Ausbilden der Passivierungsschicht auf einer Oberfläche gegenüber der Lichteinfallsoberfläche der Halbleitereinheit;
Ausbilden eines Lochs durch die Passivierungsschicht; und
Ausbilden einer Elektrodenmaterialschicht und Brennen der Elektrodenmaterialschicht zum Ausbilden der Elektrode auf der Passivierungsschicht, wobei
das Ausbilden der Passivierungsschicht auf der Halbleitereinheit aus den Schritten besteht:
Ausbilden einer Siliziumoxid-(SiOx)-Schicht, die mit der Halbleitereinheit in Kontakt steht;
Ausbilden einer Siliziumsnitrit-(SiNx)-Schicht auf der Siliziumoxidschicht; und
Ausbilden einer Siliziumsoxynitrid-(SiOxNy)-Schicht auf der Siliziumnitritschicht.

6. Verfahren gemäß Anspruch 5, wobei das Ausbilden des Lochs ein Abstrahlen eines Laserstrahls auf die Passivierungsschicht umfasst.

7. Verfahren gemäß Anspruch 5, wobei das Ausbilden des Lochs nach dem Ausbilden der Elektrodenschicht erfolgt und ein Abstrahlen eines Laserstrahls auf die Elektrodenmaterialschicht umfasst.

## Revendications

1. Cellule solaire, comprenant :
une unité de semi-conducteurs (100) incluant un semi-conducteur de premier type (101) et un semi-conducteur de deuxième type (102) ;
une première électrode (120) et une deuxième électrode (140) électriquement connectées à l'unité de semi-conducteurs (100) ; et
une couche de passivation (130) entre l'unité de semi-conducteurs (100) et la deuxième électrode (140),
ladite couche de passivation (130) étant positionnée sur une surface opposée à la surface incidente à la lumière de l'unité de semi-conducteurs (100), dans laquelle
la couche de passivation (130) est une structure à trois couches qui consiste en une première couche (200) consistant en un oxyde de silicium (SiOₓ), ladite première couche (200) contactant l'unité de semi-conducteurs (100), une deuxième couche (210) consistant en un nitrure de silicium (SiNₓ) sur la première couche (200), et une troisième couche (220) consistant en un oxynitrure de silicium (SiOₓN_{y}) sur la deuxième couche (210), ladite troisième couche (220) contactant la deuxième électrode (140), et dans laquelle
un indice de réfraction de la première couche (200) est plus petit qu'un indice de réfraction de la deuxième couche (210), et
un indice de réfraction de la troisième couche (220) est plus petit que l'indice de réfraction de la deuxième couche (210) et est plus grand que l'indice de réfraction de la première couche (200).

2. Cellule solaire selon la revendication 1, dans laquelle la deuxième couche (210) contient de l'hydrogène (H₂).

3. Cellule solaire selon la revendication 1, dans laquelle une partie de la deuxième électrode (140) est électriquement connectée à l'unité de semi-conducteurs (100) à travers la couche de passivation (130).

4. Cellule solaire selon la revendication 3, comprenant en outre une couche de champ électrique arrière (150) entre la partie de la deuxième électrode (140) qui est électriquement connectée à l'unité de semi-conducteurs (100) à travers la couche de passivation (130) et l'unité de semi-conducteurs (100).

5. Procédé de fabrication d'une cellule solaire selon la revendication 1 incluant une unité de semi-conducteurs (100), une deuxième électrode (140) qui est une électrode arrière (140), et une couche de passivation (130) entre l'unité de semi-conducteurs et l'électrode arrière, le procédé comprenant :
la formation de la couche de passivation (130) sur une surface opposée à la surface incidente à la lumière de l'unité de semi-conducteurs ;
la formation d'un trou à travers la couche de passivation ; et
la formation d'une couche de matériau d'électrode et la cuisson de la couche de matériau d'électrode pour former l'électrode sur la couche de passivation, dans lequel
la formation de la couche de passivation sur l'unité de semi-conducteurs consiste en :
la formation d'une couche d'oxyde de silicium (SiOₓ) contactant l'unité de semi-conducteurs ;
la formation d'une couche de nitrure de silicium (SiNₓ) sur la couche d'oxyde de silicium ; et
la formation d'une couche d'oxynitrure de silicium (SiOₓN_{y}) sur la couche de nitrure de silicium.

6. Procédé selon la revendication 5, dans lequel la formation du trou inclut la projection d'un faisceau laser sur la couche de passivation.

7. Procédé selon la revendication 5, dans lequel la formation du trou a lieu après la formation de la couche d'électrode, et inclut la projection d'un faisceau laser sur la couche de matériau d'électrode.
